# EUROPEAN PATENT SPECIFICATION

(11) **EP 3 937 377 B1**
(45) Date of publication and mention of the grant of the patent: **04.11.2026**
(21) Application number: 21159554.1
(22) Date of filing: 26.02.2021
(51) Int. Cl.: H03F 3/24, H03F 1/02, H03F 3/19, H03F 3/189

(54) **COMMUNICATION APPARATUS FOR SUPPORTING ENVELOPE TRACKING MODULATION AND ENVELOPE DELAY OPTIMIZATION METHOD**
KOMMUNIKATIONSVORRICHTUNG ZUR UNTERSTÜTZUNG DER HÜLLKURVENFOLGEMODULATION UND VERFAHREN ZUR OPTIMIERUNG DER HÜLLKURVENVERZÖGERUNG
APPAREIL DE COMMUNICATION PRENANT EN CHARGE LA MODULATION DE SUIVI D'ENVELOPPE ET PROCÉDÉ D'OPTIMISATION DE RETARD D'ENVELOPPE

(30) Priority: 07.07.2020 KR 20200083606
(43) Date of publication of application: 12.01.2022
(73) Proprietor: Samsung Electronics Co., Ltd., Suwon-si, Gyeonggi-do 16677 (KR)
(72) Inventor: CHOI, Hongmin, Suwon-si, Gyeonggi-do 16677 (KR); YEON, Haedong, Suwon-si, Gyeonggi-do 16677 (KR); LEE, Junse, Suwon-si, Gyeonggi-do 16677 (KR); NOH, Heesang, Suwon-si, Gyeonggi-do 16677 (KR); BAEK, Changhyun, Suwon-si, Gyeonggi-do 16677 (KR)
(74) Representative: Kuhnen & Wacker Patent- und Rechtsanwaltsbüro PartG mbB

(56) References cited:
- GB-A- 2 505 471
- US-A1- 2005 069 026
- US-A1- 2014 328 433
- US-A1- 2020 169 436

## Description

### BACKGROUND

Methods, apparatuses and systems relate to a communication device and an envelope delay optimization method, and more particularly, to a communication device that supports envelope tracking modulation and a method of optimizing an envelope delay.

In recent years, intensive efforts have been made to improve efficiency of a transmission device provided in user equipment (UE) in order to extend the battery life. In addition, in order to reduce heat loss, the area of network equipment has also been intensively studied. Various technologies have been developed under the assumption that the efficiency and radio frequency (RF) performance of most transmission devices are influenced by a power amplifier (PA).

That has been attracting attention and being constantly studied is envelope tracking (ET).

US 2005/069026 A1 discloses: An RF transceiver includes an Envelope Restoration (ER) transmitter (TX) and a receiver (RX). A method includes providing the TX with at least one programmable delay element in at least one of an AM path and a PM path; making an RF connection between an output of the TX and an input of the RX; and responsive to an output of the RX when receiving a signal through the RF connection, determining at least one delay value for use in programming the at least one programmable delay element. Making an RF connection includes measuring an effect of a delay mismatch between the AM path and the PM path for use in determining the at least one delay value.

US 2014/328433 A1 discloses: An apparatus for envelope tracking calibration for use in a wireless communication. The apparatus includes a transmission signal path configured to carry a transmission signal to an antenna. An envelope signal path configured to feed an envelope signal with an envelope tracking power amplifier. A controller is configured to transmit a normal envelope signal being generated in a normal operation mode and measure a first Adjacent Channel Leakage Ratio (ACLR) corresponding to the normal envelope signal. The controller is further configured to transmit a comparison envelope signal being generated in a comparison operation mode and measure a second ACLR corresponding to the comparison envelope signal. The controller is configured to calculate a time misalignment between the transmission signal path and the envelope signal path based on a difference between the first and second ACLRs.

### SUMMARY

The invention is set out in the appended claims and provides a method and a device for matching the phase of an input signal and an envelope, and increasing the efficiency of a power amplifier in a communication device as defined in claim 1 and an envelope delay optimization method as defined in claim 1.

### BRIEF DESCRIPTION OF THE DRAWINGS

The above, and other aspects, features and advantages will be more clearly understood from the following detailed description of example embodiments encompassed by the invention and comparative examples not encompassed by the invention, taken in conjunction with the accompanying drawings in which:
FIG. 1 is a view of a wireless communication device according to an example embodiment;
FIG. 2A is a graph of a supply voltage according to a comparative example;
FIG. 2B is a graph of a modulated supply voltage according to an example embodiment;
FIG. 2C is a graph of a supply voltage according to a comparative example that is not synchronized with an input signal;
FIG. 3 is a flowchart of an envelope delay optimization method according to an example embodiment;
FIG. 4 is a flowchart of an envelope delay optimization method according to an example embodiment;
FIGS. 5A and 5B are views illustrating frequency characteristics of test input signals in a test mode according to an example embodiment;
FIG. 6 is a view illustrating frequency characteristics of test output signals in a test mode according to an example embodiment;
FIG. 7 is a view illustrating frequency characteristics of test output signals in a test mode according to an example embodiment;
FIG. 8 is a view of a controller according to an example embodiment;
FIG. 9 is a flowchart of an envelope delay optimization method according to an example embodiment;
FIG. 10 is a flowchart of an envelope delay optimization method according to an example embodiment;
FIGS. 11A and 11B are flowcharts of an envelope delay optimization method according to an example embodiment;
FIGS. 12A and 12B are views illustrating frequency characteristics of test input signals in a test mode according to an example embodiment;
FIG. 13 is a view illustrating frequency characteristics of test output signals in a test mode according to an example embodiment; and
FIG. 14 is a view of a communication device according to an example embodiment.

### DETAILED DESCRIPTION

Hereinafter, example embodiments will be described in detail with reference to the accompanying drawings.

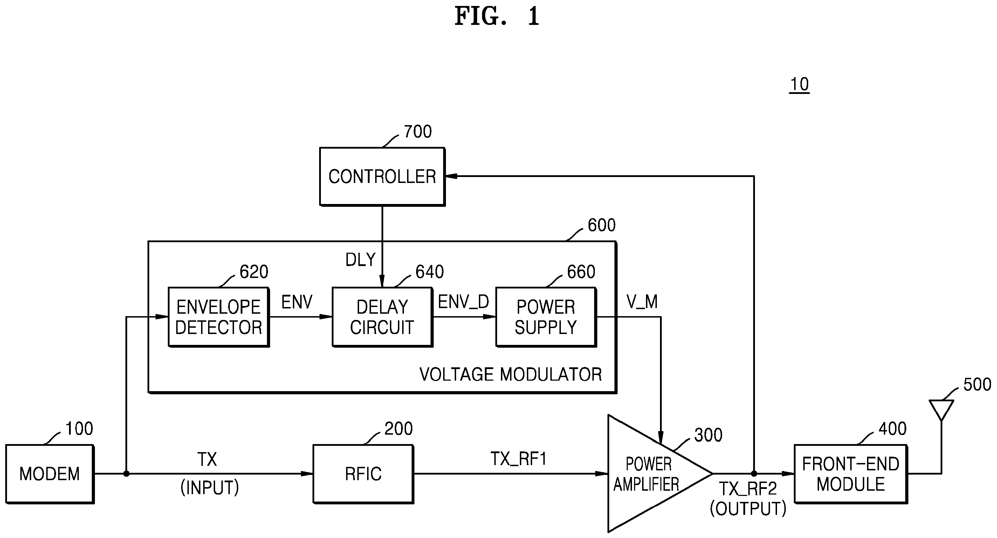

FIG. 1 is a view of a wireless communication device 10 according to an example embodiment. The wireless communication device 10 may include a modem 100, a radio frequency integrated circuit (RFIC) 200, a power amplifier 300, a front end module 400, an antenna 500, a voltage modulator 600, and a controller 700. In some example embodiments, the wireless communication device 10 may further include components not shown in FIG. 1. For example, a switch and/or a duplexer controlled according to a transmission mode or a reception mode may be between the power amplifier 300 and the front end module 400. In addition, in an example embodiment, the controller 700 may be an external device of the wireless communication device 10.

The wireless communication device 10 may connect to a wireless communication system by transmitting and receiving signals through the antenna 500. The wireless communication system to which the wireless communication device 10 connects may be referred to as a radio access technology (RAT), and may be a wireless communication system using a cellular network such as a 5th generation wireless (5G) system, a long term evolution (LTE) system, an LTE-Advanced system, a code division multiple access (CDMA) system, a global system for mobile communications (GSM) system, etc., as a non-limiting example, or may be a wireless local area network (WLAN) system or any other wireless communication system. Hereinafter, the wireless communication system to which the wireless communication device 10 connects will be described on the assumption that it is a wireless communication system using a cellular network, but it will be understood that example embodiments are not limited thereto.

A wireless communication network of the wireless communication system may support communication among multiple wireless communication devices, including the wireless communication device 10, by sharing available network resources. For example, in the wireless communication network, information may be transferred through various multiple access methods such as code division multiple access (CDMA), frequency division multiple access (FDMA), time division multiple access (TDMA), orthogonal frequency division multiple access (OFDMA), single carrier frequency division multiple access (SC-FDMA), OFDM-FDMA, OFDM-TDMA, and OFDM-CDMA.

The wireless communication device 10 may refer to any device that connects to the wireless communication system. For example, the wireless communication device 10 may refer to a base station BS. The base station BS may generally refer to a fixed station for communicating with user equipment and/or another base station, and may exchange data and control information by communicating with user equipment and/or another base station. For example, the base station may be referred to as Node B, evolved-Node B (eNB), next generation Node B (gNB), a sector, a site, a base transceiver system (BTS), an access point (AP), a relay node, a remote radio head (RRH), a radio unit (RU), a small cell, or the like. In this specification, the base station or a cell may have a comprehensive meaning indicating some areas or functions covered by a base station controller (BSC) in CDMA, Node-B in WCDMA, and eNB or the sector (site) in LTE, and may cover all of various coverage areas, such as a megacell, macrocell, microcell, picocell, femtocell, relay node, RRH, RU, and a small cell communication range.

For example, the wireless communication device 10 may refer to a user equipment (UE). The UE may be fixed or mobile, and may refer to any devices capable of transmitting and receiving data and/or control information by communicating with a base station. For example, the UE may be referred to as terminal equipment, a mobile station (MS), a mobile terminal (MT), a user terminal (UT), a subscriber station (SS), a wireless device, or a handheld device. In this specification, the wireless communication device 10 is generally described as the UE, but it will be understood that example embodiments are not limited thereto.

Referring to FIG. 1, the antenna 500 may be connected to the front end module 400, and may transmit a signal provided from the front end module 400 to another wireless communication device or may provide a signal received from another wireless communication device to the front end module 400. In FIG. 1, some components used to receive signals from other wireless communication devices through the antenna 500 may be omitted. In some example embodiments, the wireless communication device 10 may include a plurality of antennas for a phased array, multiple-input and multiple-output (MIMO), and the like.

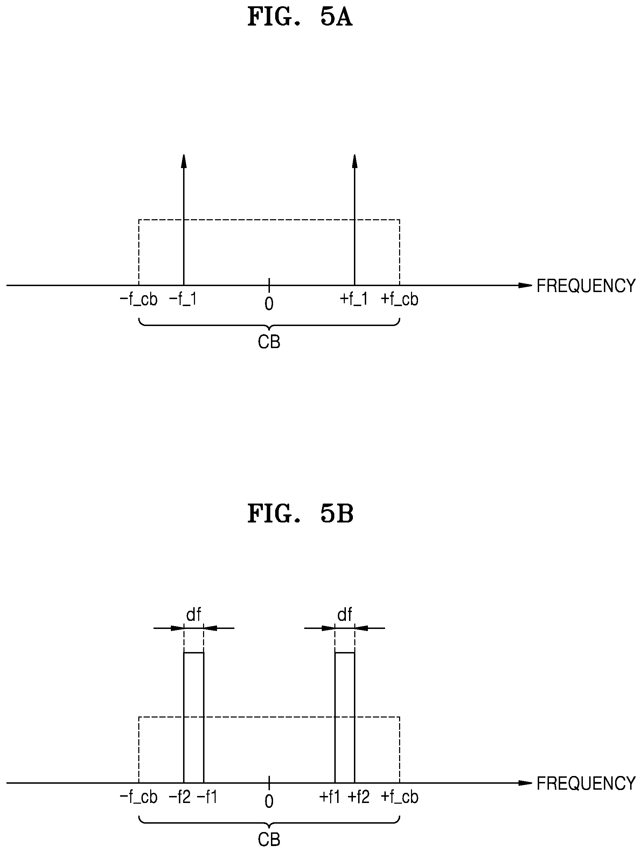

The modem 100 may generate a signal including information to be transmitted through the antenna 500. In some example embodiments, the modem 100 may include an encoder, a modulator, a filter, a digital-to-analog converter (DAC), and the like. For example, the modem 100 may generate a transmission signal TX and may provide the transmission signal TX to the RFIC 200 and the voltage modulator 600. In an example embodiment, the modem 100 may generate a baseband transmission signal in a normal mode of the wireless communication device 10 and provide the baseband transmission signal to the RFIC 200 and the voltage modulator 600. In an example embodiment, the modem 100 may generate a test input signal INPUT in a test mode of the wireless communication device 10 and provide the test input signal INPUT to the RFIC 200 and the voltage modulator 600. The test mode may refer to a mode for obtaining an optimum delay value among a plurality of test delay values by comparing respective adjacent channel leakage ratios for a plurality of test delay values. In an example embodiment, the test input signal INPUT is a signal corresponding to a plurality of frequencies selected from a channel band, and may be, for example, tone signals for at least two selected frequencies. However, example embodiments are not limited thereto. The test input signal INPUT may include a plurality of frequency band signals, and each of the plurality of frequency bands is a unit frequency band generated by a resource block, and may be a band including at least one frequency. The test input signal INPUT will be described in more detail with reference to FIGS. 5A and 5B.

The RFIC 200 may receive the transmission signal TX from the modem 100 and may generate a first RF transmission signal TX_RF1 from the transmission signal TX. For example, the RFIC 200 may include a mixer, a filter, and an amplifier. The RFIC 200 may be included on a signal transmission path through which the transmission signal TX is transmitted, and may transmit the transmission signal TX to the power amplifier 300.

The power amplifier 300 may generate a second RF transmission signal TX_RF2 by amplifying the first RF transmission signal TX_RF1 by using power provided by a modulated supply voltage V_M. In a test mode of the wireless communication device 10, the test input signal INPUT generated by the modem 100 is provided to the power amplifier 300 through the signal transmission path including the RFIC 200, and the power amplifier 300 may output a test output signal OUTPUT based on the test input signal INPUT received through the signal transmission path. The power amplifier 300 may provide the test output signal OUTPUT to the controller 700.

The voltage modulator 600 may modulate a supply voltage provided to the power amplifier 300 based on an envelope signal ENV generated by detecting an envelope of the transmission signal TX. For example, the voltage modulator 600 may generate the modulated supply voltage V_M following the envelope signal ENV, and may provide the modulated supply voltage V_M to the power amplifier 300. The voltage modulator 600 may include an envelope detector 620, a delay circuit 640, and a power supply 660.

The envelope detector 620 may generate the envelope signal ENV by detecting an envelope of the transmission signal TX provided from the modem 100. The envelope detector 620 may provide the envelope signal ENV to the delay circuit 640.

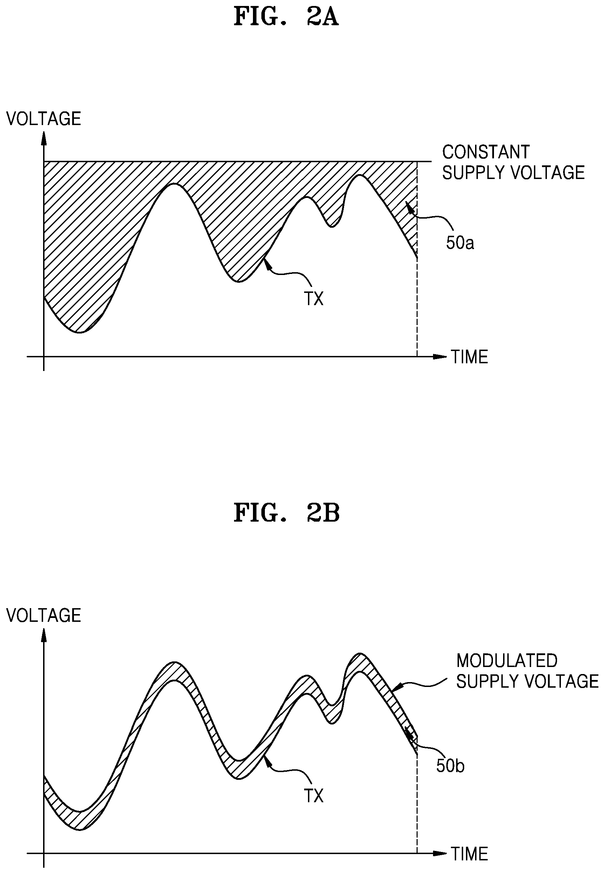

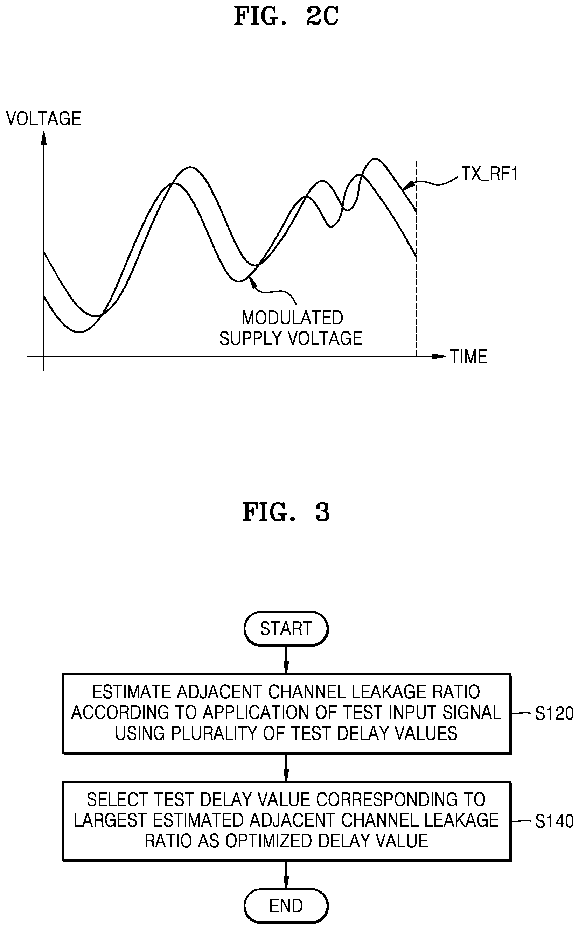

The delay circuit 640 may generate a delayed envelope signal ENV_D by delaying the envelope signal ENV based on a delay value DLY provided by the controller 700, and may provide the delayed envelope signal ENV_D to the power supply 660. For example, in the test mode, the delay circuit 640 may generate the delayed envelope signal ENV_D by delaying the envelope signal ENV based on each of a plurality of test delay values provided as the delay value DLY from the controller 700. In addition, for example, in the normal mode, the delay circuit 640 may generate the delayed envelope signal ENV_D by delaying the envelope signal ENV based on an optimized delay value provided as the delay value DLY from the controller 700, The reason why the delay of the envelope signal ENV is required will be described in more detail with reference to FIGS. 2B and 2C.

The power supply 660 may generate the modulated supply voltage V_M based on the delayed envelope signal ENV_D, and may provide the modulated supply voltage V_M to the power amplifier 300.

The controller 700 may control the delay circuit 640 based on the delay value DLY. For example, the controller 700 may control the delay circuit 640 by providing the optimized delay value as the delay value DLY to the delay circuit 640 in the normal mode. Also, for example, the controller 700 may control the delay circuit 640 by providing each of the plurality of test delay values as the delay value DLY to the delay circuit 640 in the test mode.

In an example embodiment, the controller 700 may select one of a plurality of test delay values as the optimized delay value. To this end, in the test mode, the controller 700 may estimate an adjacent channel leakage ratio based on the test output signal OUTPUT for each of the plurality of test delay values. In more detail, in the test mode, the controller 700 may provide a test delay value as the delay value DLY to the delay circuit 640, the voltage modulator 600 may provide the modulated supply voltage V_M based on a delayed envelope signal based on the test delay value to the power amplifier 300, and the power amplifier 300 may output the test output signal OUTPUT by amplifying the test input signal INPUT received through a signal transmission path using the modulated supply voltage V_M. When the test input signal INPUT is a tone signal for a plurality of selected frequencies, the test output signal OUTPUT may include a fundamental frequency component and an inter-modulated component. The fundamental frequency component may indicate a component corresponding to the plurality of selected frequencies. In addition, the inter-modulated component is a harmonic component of the plurality of selected frequencies, and may include a 3rd-order inter-modulated component and a 5th-order inter-modulated component in an example embodiment. The controller 700 may estimate an adjacent channel leakage ratio based on a ratio of the magnitude of the fundamental frequency component and the magnitude of the inter-modulated component included in the test output signal OUTPUT. In other words, the controller 700 may obtain a plurality of estimated adjacent channel leakage ratios for a plurality of test delay values. The controller 700 may select a test delay value corresponding to the largest adjacent channel leakage ratio among the plurality of estimated adjacent channel leakage ratios, and may use the selected test delay value as an optimized delay value.

As technology advances, a bandwidth of the transmission signal TX continues to widen. In order to measure an adjacent channel leakage ratio for the transmission signal TX having a wide bandwidth, a wireless communication device according to a comparative example needs to support a high sampling rate. For example, in order to measure an adjacent channel leakage ratio for the transmission signal TX having a bandwidth of 100 MHz, the wireless communication device according to the comparative example needs to support a sampling rate of at least 300 MHz. However, for the wireless communication device to support a high sampling rate, it requires excessive power consumption or a high hardware cost.

According to the wireless communication device 10 according to an example embodiment, in a test mode, an adjacent channel leakage ratio may be estimated based on the magnitudes of a fundamental frequency component and an inter-modulated component included in the test output signal OUTPUT output according to the input of the test input signal INPUT, such as a tone signal corresponding to a plurality of frequencies selected in a channel band. In particular, when an inter-modulated frequency corresponding to the inter-modulated component is greater than a sampling rate (or half of the sampling rate), the controller 700 may estimate the adjacent channel leakage ratio based on the magnitudes of the fundamental frequency component and an aliased inter-modulated component.

Furthermore, the wireless communication device 10 according to an example embodiment may select an optimized delay value among a plurality of test delay values by estimating adjacent channel leakage ratios for the plurality of test delay values, and may synchronize the transmission signal TX with the envelope signal ENV by controlling the delay circuit 640 based on the optimized delay value in the normal mode. Accordingly, the efficiency of the power amplifier 300 may be increased.

FIG. 2A is a graph of a supply voltage according to a comparative example. FIG. 2A shows a graph of the transmission signal TX and the supply voltage over time when the supply voltage applied to a power amplifier is a constant voltage.

When the supply voltage applied to the power amplifier is constant, because a value of the supply voltage needs to be greater than the maximum value of the transmission signal TX, a time period occurs in which a difference between the transmission signal TX and the supply voltage widens.

Accordingly, heat loss occurs in the graph by an amount corresponding to an area 50a between a supply voltage line and the transmission signal TX.

FIG. 2B is a graph of a modulated supply voltage according to an example embodiment. In particular, FIG. 2B shows a graph of the first RF transmission signal TX_RF1 and the modulated supply voltage over time when the modulated supply voltage is applied to the power amplifier 300, according to an example embodiment. FIG. 2B is described with reference to FIG. 1.

The voltage modulator 600 included in the wireless communication device 10 according to an example embodiment may detect the envelope signal ENV from the transmission signal TX, and may generate the modulated supply voltage V_M such that the modulated supply voltage V_M follows an envelope of the transmission signal TX.

Accordingly, it can be seen that an area 50b between a modulated supply voltage line indicating heat loss and the transmission signal TX is very small compared to the area 50a of FIG. 5A. In other words, it can be stated that as the modulated supply voltage V_M follows the envelope of the transmission signal TX, heat loss of the wireless communication device 10 is reduced and thermal efficiency is increased.

FIG. 2C is a graph of a supply voltage according to a comparative example that is not synchronized with an input signal. FIG. 2C shows a graph when the modulated supply voltage supplied to the power amplifier and the first RF transmission signal TX_RF1 are not synchronized with each other. FIG. 2C is described with reference to FIG. 1.

Referring to FIG. 1, a path of the transmission signal TX output from the modem 100 to the power amplifier 300 through the RFIC 200 and a path to reach the power amplifier 300 through the voltage modulator 600 are different from each other, and a phase of the modulated supply voltage V_M input to the power amplifier 300 and a phase of the first RF transmission signal TX_RF1 may not match each other (or may not be synchronized with each other).

In the case of FIG. 2C, compared to the example embodiment of FIG. 2B, a linearity characteristic of the power amplifier 300 may be deteriorated. Accordingly, the wireless communication device 10 needs to delay the envelope signal ENV by an appropriate delay value to match the phases of the modulated supply voltage V_M and the first RF transmission signal TX_RF1 with each other.

According to the wireless communication device 10 according to an example embodiment, the controller 700 provides an optimized delay value to the delay circuit 640 so that the phase of the modulated supply voltage V_M input and the phase of the first RF transmission signal TX_RF1 may match each other.

FIG. 3 is a flowchart of an envelope delay optimization method according to an example embodiment. FIG. 3 is described with reference to FIG. 1.

In operation S120, in the test mode, the wireless communication device 10 estimates an adjacent channel leakage ratio by applying the test input signal INPUT using a plurality of test delay values. For example, in the test mode, the modem 100 outputs the test input signal INPUT corresponding to a plurality of frequencies selected in a channel band. The voltage modulator 600 outputs the modulated supply voltage V_M based on the test input signal INPUT using each of a plurality of test delay values. The controller 700 estimates the adjacent channel leakage ratio using the test output signal OUTPUT output from the power amplifier 300 based on the modulated supply voltage V_M. Through this, the controller 700 obtains a plurality of estimated adjacent channel leakage ratios respectively corresponding to the plurality of test delay values.

In operation S140, the wireless communication device 10 selects a test delay value corresponding to the largest estimated adjacent channel leakage ratio among the plurality of estimated adjacent channel leakage ratios as an optimized delay value. The controller 700 provides the optimized delay value as the delay value DLY to the delay circuit 640 in the normal mode, and the delay circuit 640 outputs the delayed envelope signal ENV_D by delaying the envelope signal ENV based on the delay value DLY. The power supply 660 outputs the modulated supply voltage V_M based on the delayed envelope signal ENV_D.

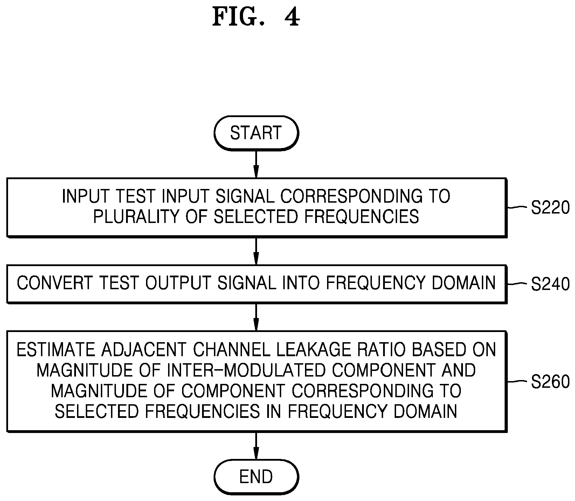

FIG. 4 is a flowchart of an envelope delay optimization method according to an example embodiment. In particular, FIG. 4 may be a flowchart illustrating a detailed example embodiment of operation S120 of FIG. 3. FIG. 4 is described with reference to FIG. 1.

In operation S220, the wireless communication device 10 may input the test input signal INPUT corresponding to a plurality of selected frequencies to a signal transmission path including the power amplifier 300. For example, the test input signal INPUT may be a tone signal corresponding to a plurality of frequencies selected in a channel band, as shown in FIG. 5A. In addition, in an example embodiment, the test input signal INPUT may be a signal including a small frequency band that includes the plurality of selected frequencies, as shown in FIG. 5B.

In operation S240, the wireless communication device 10 may convert the test output signal OUTPUT into a frequency domain. For example, the controller 700 may convert the test output signal OUTPUT output from the power amplifier 300 into a frequency domain according to an input of the test input signal INPUT. In an example embodiment, the controller 700 may convert the test output signal OUTPUT into the frequency domain by performing a Fourier transform using the test output signal OUTPUT. In an example embodiment, the controller 700 may convert the test output signal OUTPUT into the frequency domain by performing a fast Fourier transform (FFT) using the test output signal OUTPUT.

In operation S260, the wireless communication device 10, in the frequency domain, estimates an adjacent channel leakage ratio based on the magnitude of an inter-modulated component and the magnitude of a component corresponding to the plurality of selected frequencies. For example, the controller 700, in the frequency domain, may estimate the adjacent channel leakage ratio based on a ratio of the magnitude of a fundamental frequency component and the magnitude of the inter-modulated component included in the test output signal OUTPUT. In an example embodiment, the inter-modulated component includes a 3rd-order inter-modulated component and/or a 5th-order inter-modulated component. Also, in an example embodiment, when half of a sampling rate is less than three times a selected frequency, the controller 700 estimates an adjacent channel leakage ratio based on a ratio of the magnitude of the fundamental frequency component and the magnitude of an aliased inter-modulated component.

FIGS. 5A and 5B are views illustrating frequency characteristics of test input signals in a test mode according to an example embodiment. FIGS. 5A and 5B may illustrate an example embodiment of the test input signal INPUT of FIG. 1. FIGS. 5A and 5B are described with reference to FIG. 1.

Referring to FIG. 5A, the test input signal INPUT may be a tone signal corresponding to a plurality of frequencies selected in a channel band CB. The plurality of selected frequencies may include a first frequency and a second frequency, wherein the second frequency may be a frequency having the same magnitude as the first frequency and different only in sign. For example, the plurality of selected frequencies may include a positive first frequency +f_1 and a negative first frequency -f_1. In other words, the test input signal INPUT may be a tone signal having a positive first frequency +f_1 component and a negative first frequency -f_1 component. The first frequency f_1 may be equal to or less than a channel band frequency f_cb. The channel band frequency f_cb may correspond to half of a bandwidth of the channel band CB, and in an example embodiment, the first frequency f_1 may be the channel band frequency f_cb.

Referring to FIG. 5B, the test input signal INPUT may include a plurality of bandwidth components corresponding to a plurality of frequencies selected in the channel band CB, and each of the plurality of bandwidth components may include a component corresponding to the plurality of frequencies and may correspond to a unit bandwidth signal generated by a resource block in the modem 100. For example, the plurality of selected frequencies may include the positive first frequency +f_1 and the negative first frequency -f_1. The test input signal INPUT includes a component corresponding to the positive first frequency +f_1 and may include a bandwidth component having a bandwidth df, and includes a component corresponding to the negative first frequency -f_1 and may include the bandwidth component having the bandwidth df. The bandwidth df may correspond to a unit bandwidth of one resource block in the modem 100.

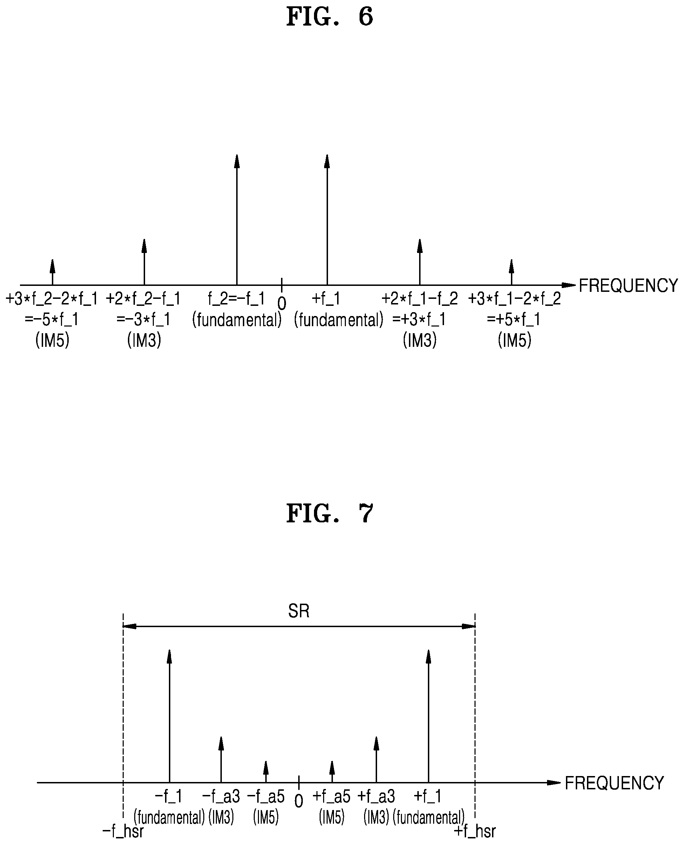

FIG. 6 is a view illustrating frequency characteristics of test output signals in a test mode according to an example embodiment. In particular, FIG. 6 may be a view illustrating frequency characteristics of test output signals generated according to an input of a test input signal as shown in FIG. 5A. FIG. 6 is described with reference to FIG. 1.

Referring to FIG. 5A, the test input signal INPUT may include a component corresponding to the positive first frequency +f_1 and a component corresponding to the negative first frequency -f_1. In other words, the test input signal INPUT may include a component corresponding to a first frequency f_1 and a component corresponding to a second frequency f_2, and the second frequency f_2 may be the negative first frequency -f_1. The test output signal OUTPUT, which is output in response to the test input signal INPUT being input to a signal transmission path including the RFIC 200 and the power amplifier 300, may include a fundamental frequency component and an inter-modulated component corresponding to each of a plurality of selected frequencies. For example, the test output signal OUTPUT may include a fundamental frequency component, a 3rd-order inter-modulated component and a 5th-order inter-modulated component. The fundamental frequency component may include a component corresponding to the positive first frequency +f_1 and a component corresponding to the negative first frequency -f_1. The 3rd-order inter-modulated component may include a component corresponding to 2*f_1-f_2 and a component corresponding to 2*f_2-f_1. In an example embodiment, when f_2 is equal to -f_1, the 3rd-order inter-modulated component may include a component corresponding to 3*f_1 and a component corresponding to -3*f_1. The 5th-order inter-modulated component may include a component corresponding to 3*f_1-f_2 and a component corresponding to 3*f_2-f_1. In an example embodiment, when f_2 is equal to -f_1, the 5th-order inter-modulated component may include a component corresponding to 5*f_1 and a component corresponding to -5*f_1.

The controller 700 according to an example embodiment estimates an adjacent channel leakage ratio based on a ratio of the magnitude of the fundamental frequency component and the magnitude of the inter-modulated component by converting the test output signal OUTPUT to a frequency domain.

FIG. 6 shows frequency characteristics of the test output signal OUTPUT when a half sampling frequency corresponding to half of a sampling rate of the wireless communication device 10 is greater than 3 times and 5 times a selected frequency (e.g., the first frequency f_1). When the half sampling frequency is less than three times the first frequency f_1, inter-modulated components of the test output signal OUTPUT are aliased. Aliased inter-modulated components will be described in more detail with reference to FIG. 7 below.

FIG. 7 is a view illustrating frequency characteristics of test output signals in a test mode according to an example embodiment. In particular, FIG. 7 may show frequency characteristics of test output signals generated according to the input of the test input signal INPUT as shown in FIG. 5A in the wireless communication device 10 supporting a limited sampling rate SR. In particular, FIG. 7 shows a case in which a half sampling frequency f_hsr corresponding to half the sampling rate SR is greater than the first frequency f_1 but less than 3 times the first frequency f_1 as compared with FIG. 6.

Because the first frequency f_1 corresponding to a fundamental frequency component of the test output signal OUTPUT is less than the half sampling frequency f_hsr, the test output signal OUTPUT may have a fundamental frequency component corresponding to the positive first frequency +f_1 and the negative first frequency -f_1 without moving a position in a frequency domain.

Additionally, because a frequency corresponding to the 3rd-order inter-modulated component of the test output signal OUTPUT is greater than the half sampling frequency f_hsr, the 3rd-order inter-modulated component is down-sampled, and a component corresponding to the 3rd-order inter-modulated component may appear at a 3rd-order aliasing frequency f_a3. The component appearing at the 3rd-order aliasing frequency f_a3 will be referred to as an aliased 3rd-order inter-modulated component. A relationship between the 3rd-order aliasing frequency f_a3 and the first frequency f_1 is shown in Equation 1 below. [Equation 1] $f a 3 = 3 * f 1 - f hsr * \left⌈3*f 1/f hsr\right⌉$

In Equation 1, a symbol '[]' is a Gaussian function and is a function that outputs the largest integer among integers that are not larger than an input value. As a non-limiting example for convenience of description, when the first frequency f_1 is 50 MHz and the sampling rate SR is 122.88 MHz, the Gaussian function may be 2, and may be obtained by multiplying 3 by 50 MHz and dividing by 61.44 MHz, which is 2.44. The largest integer among integers that are not larger than 2.44 is 2. Therefore, the third aliasing frequency f_a3 may be 27.12 MHz obtained by subtracting a value obtained by multiplying 2 by 61.44 MHz from 150 MHz.

Likewise, because a frequency corresponding to the 5th-order inter-modulated component of the test output signal OUTPUT is greater than the half sampling frequency f_hsr, the 5th-order inter-modulated component is down-sampled, and a component corresponding to the 5th-order inter-modulated component may appear at a 5th-order aliasing frequency f_a5. The component appearing at the 5th-order aliasing frequency f_a5 will be referred to as an aliased 5th-order inter-modulated component. A relationship between the 5th-order aliasing frequency f_a5 and the first frequency f_1 may be as shown in Equation 2 below. [Equation 2] $f_a 5 = 5 * f_ 1 - f_hsr * \left[5*f_1/f_hsr\right]$

In Equation 2, [] is a Gaussian function and is a function that outputs the largest integer among integers that are not larger than an input value. As a non-limiting example for convenience of description, when the first frequency f_1 is 50 MHz and the sampling rate SR is 122.88 MHz, the Gaussian function may be 4, and may be obtained by multiplying 5 by 50 MHz and dividing by 61.44 MHz, which is 4.06. The largest integer among integers that are not larger than 4.06 is 4. Therefore, the 5th-order aliasing frequency f_a5 may be 4.24 MHz obtained by subtracting a value obtained by multiplying 4 by 61.44 MHz from 250 MHz. As a non-limiting example for convenience of description, when the first frequency f_1 is 40 MHz and the sampling rate SR is 122.88 MHz (i.e., when the half sampling frequency f_hsr is 61.44 MHz), the 5th-order aliasing frequency f_a5 may be 15.68 MHz obtained by subtracting a value obtained by multiplying 3 by 61.44 MHz from 200 MHz.

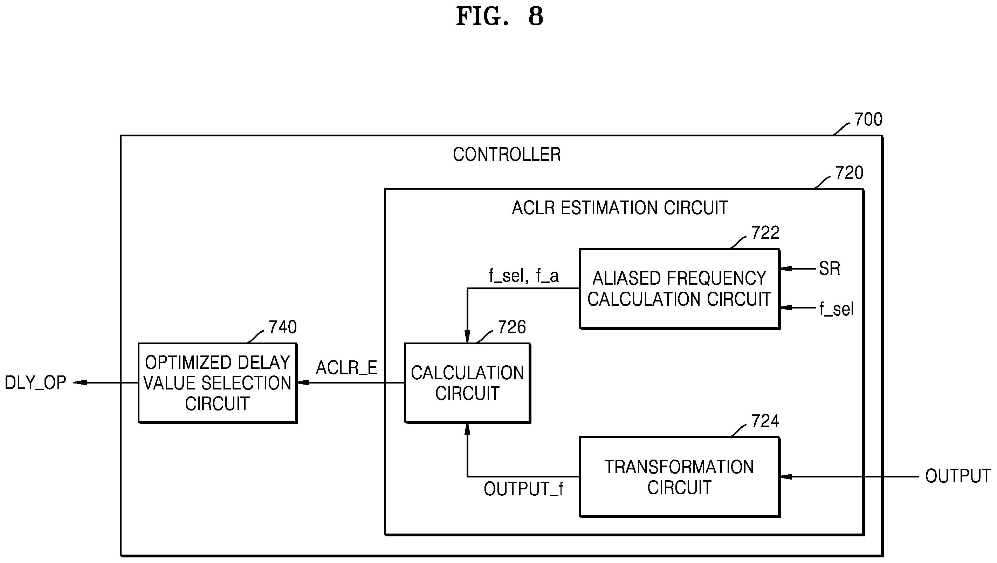

FIG. 8 is a view of the controller 700 according to an example embodiment. The controller 700 may correspond to the controller 700 of FIG. 1. FIG. 8 is described with reference to FIG. 1.

The controller 700 may include an adjacent channel leakage ratio (ACLR) estimation circuit 720 and an optimized delay value selection circuit 740.

In a test mode, the ACLR estimation circuit 720 may estimate a channel adjacent leakage ratio based on the test output signal OUTPUT according to a test delay value, and may generate an estimated channel adjacent leakage ratio ACLR_E. For example, the ACLR estimation circuit 720 may convert the test output signal OUTPUT into a frequency domain, and may obtain a plurality of aliasing frequencies f_a based on the sampling rate SR and a plurality of selected frequencies f_sel. The ACLR estimation circuit 720, based on a converted test output signal OUTPUT_f, may obtain the estimated channel adjacent leakage ratio ACLR_E based on the magnitude of a component corresponding to the plurality of selected frequencies f_sel and the magnitude of a component corresponding to the plurality of aliasing frequencies f_a.

To this end, the ACLR estimation circuit 720 may include an aliasing frequency calculation circuit 722, a transformation circuit 724, and a calculation circuit 726.

The aliasing frequency calculation circuit 722 may obtain the plurality of aliasing frequencies f_a based on the sampling rate SR and the plurality of selected frequencies f_sel within a channel band. For example, the aliasing frequency calculation circuit 722 may obtain a 3rd-order aliasing frequency and/or a 5th-order aliasing frequency in the same manner as in Equation 1 and Equation 2. The aliasing frequency calculation circuit 722 may provide the plurality of selected frequencies f_sel and the plurality of aliasing frequencies f_a to the calculation circuit 726.

The transformation circuit 724 may output the converted test output signal OUTPUT_f by converting the test output signal OUTPUT into the frequency domain. The transformation circuit 724 may sample the test output signal OUTPUT at the sampling rate SR. For example, the transformation circuit 724 may transform the test output signal OUTPUT using a Fourier transform, and in an example embodiment, the transformation circuit 724 may use a fast Fourier transform.

The calculation circuit 726 may obtain an estimated adjacent channel leakage ratio ACLR_E based on the magnitude of a component corresponding to the plurality of selected frequencies f_sel included in the converted test output signal OUTPUT_f and the magnitude of a component corresponding to the plurality of aliasing frequencies f_a. For example, the calculation circuit 726 may obtain an estimated adjacent channel leakage ratio ACLR_E by dividing the magnitude of the component corresponding to the plurality of selected frequencies f_sel included in the converted test output signal OUTPUT_f by the magnitude of the component corresponding to the plurality of aliasing frequencies f_a. The calculation circuit 726 may provide the estimated adjacent channel leakage ratio ACLR_E to the optimized delay value selection circuit 740.

The optimized delay value selection circuit 740 may accumulate a plurality of estimated adjacent channel leakage ratios corresponding to a plurality of test delay values. The optimized delay value selection circuit 740 selects a test delay value corresponding to the largest adjacent channel leakage ratio among the plurality of estimated adjacent channel leakage ratios as an optimized delay value DLY_OP. The controller 700 provides the optimized delay value DLY_OP to the delay circuit 640 in a normal mode.

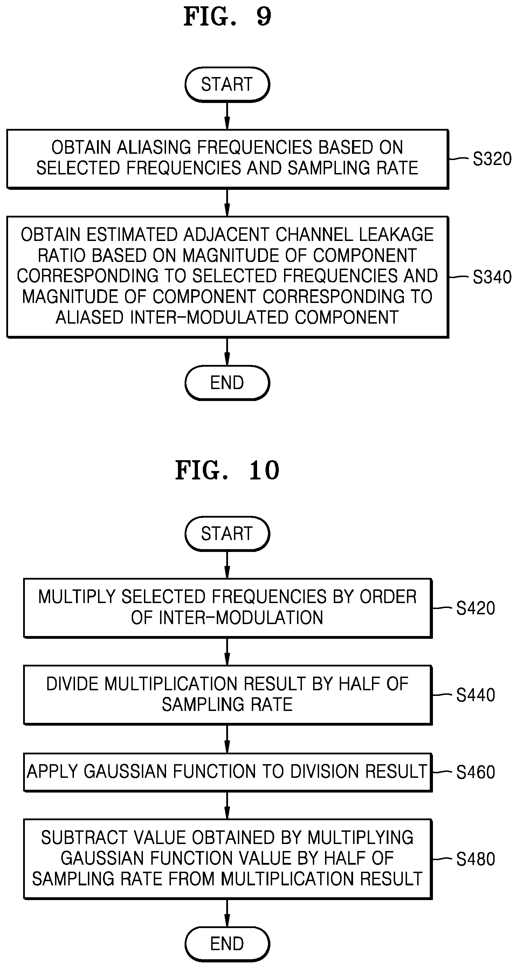

FIG. 9 is a flowchart of an envelope delay optimization method according to an example embodiment. In particular, FIG. 9 may show a detailed flowchart of operation S260 of FIG. 4. FIG. 9 is described with reference to FIGS. 1 and 8.

In operation S320, the controller 700 may obtain the plurality of aliasing frequencies f_a based on the plurality of selected frequencies f_sel and the sampling rate SR. The plurality of aliasing frequencies f_a may be obtained with reference to Equation 1 and Equation 2, and may be obtained with reference to FIG. 10 below.

In operation S340, the controller 700 obtains the estimated adjacent channel leakage ratio ACLR_E based on the magnitude of a component corresponding to the plurality of selected frequencies f_sel and the magnitude of a component corresponding to an aliased inter-modulated component.

FIG. 10 is a flowchart of an envelope delay optimization method according to an example embodiment. In particular, FIG. 10 may show a detailed flowchart of operation S320 of FIG. 9. That is, FIG. 10 may be a flowchart of a method of obtaining an aliasing frequency based on Equation 1 and Equation 2. FIG. 10 is described with reference to FIGS. 1 and 8.

In operation S420, the controller 700 may obtain a multiplication result by multiplying a plurality of selected frequencies by an order of inter-modulation. For example, when obtaining an aliasing frequency corresponding to a 3rd-order inter-modulated component, the controller 700 may multiply the selected frequency by 3, and when obtaining an aliasing frequency corresponding to a 5th-order inter-modulated component, the controller 700 may multiply the selected frequency by 5.

In operation S440, the controller 700 may divide the multiplication result by half of the sampling rate SR. For example, the controller 700 may divide the multiplication result of operation S420 by the half sampling frequency f_hsr corresponding to half of the sampling rate SR.

In operation S460, the controller 700 may apply a Gaussian function to a division result. For example, the controller 700 may obtain a Gaussian function value by applying the Gaussian function to the division result in operation S440.

In operation S480, the controller 700 may subtract a value obtained by multiplying the Gaussian function value by half of the sampling rate SR from the multiplication result in operation S420. For example, the controller 700 may obtain the aliasing frequency by subtracting a value obtained by multiplying the Gaussian function value of the operation S460 by the half sampling frequency f_hsr from the multiplication result of operation S420.

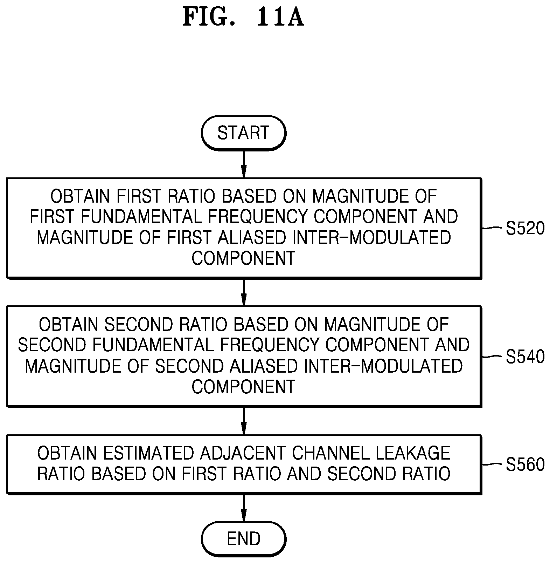

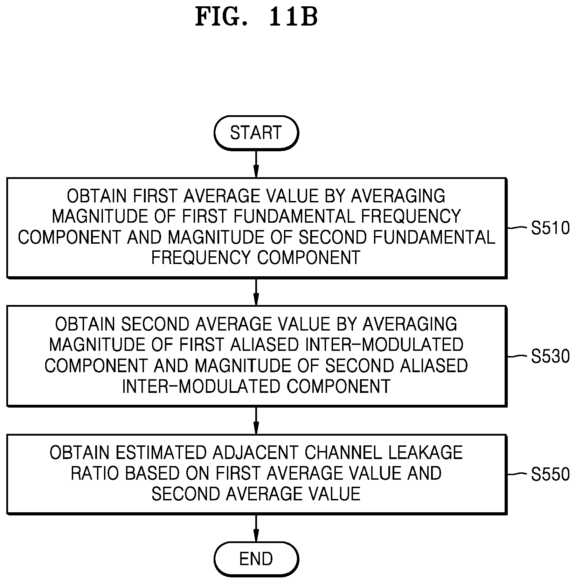

FIGS. 11A and 11B are flowcharts of an envelope delay optimization method according to an example embodiment. In particular, FIGS. 11A and 11B may show detailed flowcharts of operation S320 of FIG. 9. FIGS. 11A and 11B are described with reference to FIGS. 1 and 8.

For convenience of explanation, it is assumed that the test input signal INPUT is a tone signal corresponding to a first frequency and a second frequency. In an example embodiment, the second frequency may correspond to a negative first frequency.

The test output signal OUTPUT may include a first fundamental frequency component corresponding to the first frequency and an inter-modulated component corresponding to the first frequency. In an example embodiment, the inter-modulated component corresponding to the first frequency may be aliased due to a limitation of a sampling rate. In addition, the test output signal OUTPUT may include a second fundamental frequency component corresponding to the second frequency and an inter-modulated component corresponding to the second frequency. In an example embodiment, the inter-modulated component corresponding to the second frequency may be aliased due to a limitation of a sampling rate.

Referring to FIG. 11A, in operation S520, the controller 700 may obtain a first ratio based on the magnitude of the first fundamental frequency component and the magnitude of a first aliased inter-modulated component. For example, the controller 700 may obtain the first ratio by dividing the magnitude of the first fundamental frequency component by the magnitude of the first aliased inter-modulated component.

In operation S540, the controller 700 may obtain a second ratio based on the magnitude of the second fundamental frequency component and the magnitude of a second aliased inter-modulated component. For example, the controller 700 may obtain the second ratio by dividing the magnitude of the second fundamental frequency component by the magnitude of the second aliased inter-modulated component.

In operation S560, the controller 700 may obtain the estimated adjacent channel leakage ratio ACLR_E based on the first ratio and the second ratio. In an example embodiment, the controller 700 may obtain the estimated adjacent channel leakage ratio ACLR_E by averaging the first ratio and the second ratio. Alternatively, in an example embodiment, the controller 700 may select a smaller value of the first ratio and the second ratio as the estimated adjacent channel leakage ratio ACLR_E.

Referring to FIG. 11B, in operation S510, the controller 700 may obtain a first average value by averaging the magnitude of the first fundamental frequency component and the magnitude of the second fundamental frequency component.

In operation S530, the controller 700 may obtain a second average value by averaging the magnitude of the first aliased inter-modulated component and the magnitude of the second aliased inter-modulated component.

In operation S550, the controller 700 may obtain the estimated adjacent channel leakage ratio ACLR_E based on the first average value and the second average value. For example, the controller 700 may obtain the estimated adjacent channel leakage ratio ACLR_E by dividing the first average value by the second average value.

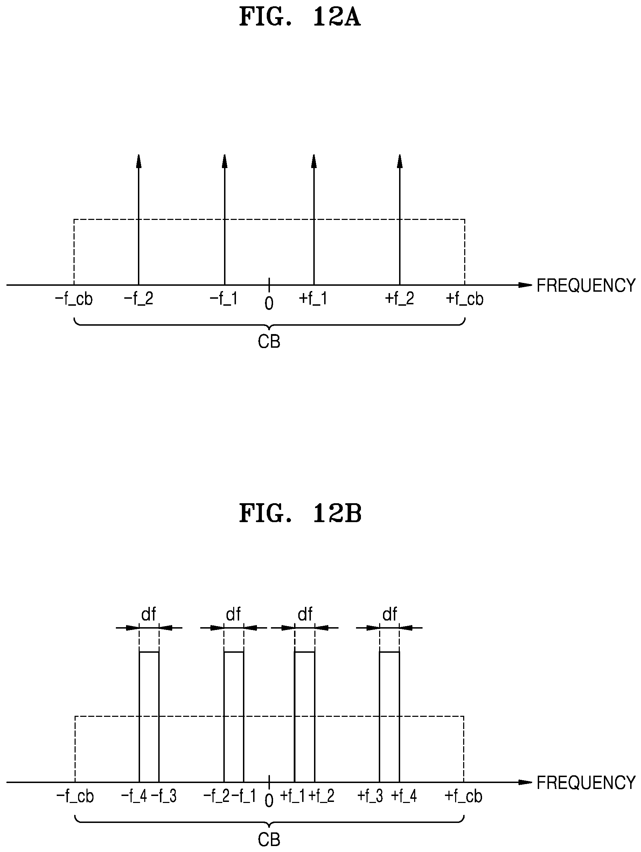

FIGS. 12A and 12B are views illustrating frequency characteristics of test input signals in a test mode according to an example embodiment. FIGS. 12A and 12B illustrate an example of the test input signal INPUT of FIG. 1. FIGS. 12A and 12B are described with reference to FIG. 1.

Referring to FIG. 12A, the test input signal INPUT may be a tone signal corresponding to a plurality of selected frequencies in the channel band CB. For example, the plurality of selected frequencies may include the positive first frequency +f_1, the negative first frequency -f_1, a positive second frequency +f_2, and a negative second frequency -f_2. In other words, the test input signal INPUT may be a tone signal having the positive first frequency +f_1 component, the negative first frequency -f_1 component, a positive second frequency +f_2 component, and a negative second frequency -f_2 component. The first frequency f_1 and the second frequency f_2 may be equal to or less than the channel band frequency f_cb. The channel band frequency f_cb may correspond to half of a bandwidth of the channel band CB, and in an example embodiment, the second frequency f_1 may be the channel band frequency f_cb.

Referring to FIG. 12B, the test input signal INPUT may include a plurality of bandwidth components respectively corresponding to the plurality of selected frequencies in the channel band CB, and each of the plurality of bandwidth components may include a component corresponding to the plurality of frequencies and may correspond to a unit bandwidth signal generated by a resource block in the modem 100. For example, the plurality of selected frequencies may include the positive first frequency +f_1, the negative first frequency -f_1, a positive third frequency +f_3, and a negative third frequency -f_3. The test input signal INPUT includes a component corresponding to the positive first frequency +f_1 and may include a bandwidth component having the bandwidth df, includes a component corresponding to the negative first frequency -f_1 and may include a bandwidth component having the bandwidth df, includes a component corresponding to the positive third frequency +f_3 and may include a bandwidth component having the bandwidth df, and includes a component corresponding to the negative third frequency -f_3 and may include a bandwidth component having the bandwidth df. The bandwidth df may correspond to a unit bandwidth of one resource block in the modem 100.

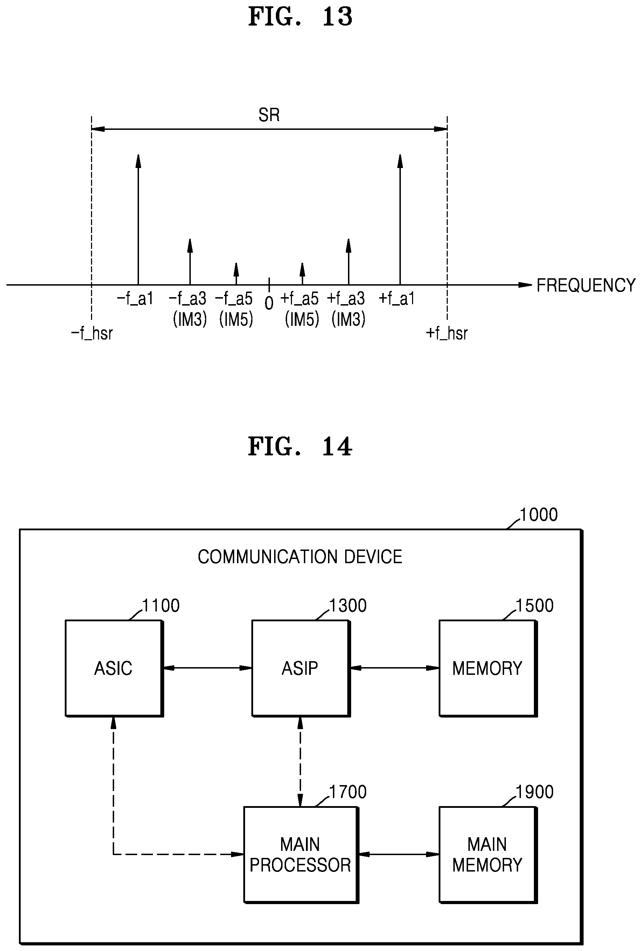

FIG. 13 is a view illustrating frequency characteristics of test output signals in a test mode according to an example embodiment. FIG. 13 will be described based on differences from FIG. 7. FIG. 13 is described with reference to FIG. 1.

In particular, FIG. 13 may show a frequency characteristic of the test output signal OUTPUT corresponding to a case where the half sampling frequency f_hsr is less than a first frequency, which is a selected frequency.

In the example embodiment as shown in FIG. 13, the controller 700 may obtain an estimated adjacent channel leakage ratio based on a frequency component corresponding to an aliased first frequency f_a1, wherein the selected frequency is a down-sampled frequency, and aliased inter-modulated components, not a component corresponding to the selected frequency.

FIG. 14 is a view of a wireless communication device 1000 according to an example embodiment. As illustrated in FIG. 14, the wireless communication device 1000 may include an application specific integrated circuit (ASIC) 1100, an application specific instruction set processor (ASIP) 1300, a memory 1500, a main processor 1700, and a main memory 1900. At least two of the ASIC 1100, the ASIP 1300, and the main processor 3700 may communicate with each other. Furthermore, at least two of the ASIC 1100, the ASIP 1300, the memory 1500, the main processor 1700, and the main memory 1900 may be included in a single chip.

The ASIP 3300 is an integrated circuit customized for a specific application, and may support an exclusive instruction set for a specific application and may execute an instruction included in the instruction set. The memory 1500 may communicate with the ASIP 1300, and may store a plurality of instructions executed by the ASIP 1300 as a non-transitory storage device. For example, the memory 3500 may include any type of memory accessible by the ASIP 1300 such as random-access memory (RAM), read-only memory (ROM), tape, a magnetic disk, an optical disk, a volatile memory, a nonvolatile memory, and a combination thereof, as non-limiting examples.

The main processor 1700 may control the wireless communication device 1000 by executing a plurality of instructions. For example, the main processor 1700 may control the ASIC 1100 and the ASIP 1300, and may process data received through an MIMO channel or a user's input to the wireless communication device 1000. The main memory 1900 may communicate with the main processor 1700, and may store a plurality of instructions executed by the main memory 1900 as a non-transitory storage device. For example, the main memory 1900 may include any type of memory accessible by the main processor 1700 such as RAM, ROM, tape, a magnetic disk, an optical disk, a volatile memory, a nonvolatile memory, and a combination thereof, as non-limiting examples.

The method of optimizing a delay value of an envelope signal and the method of operating a power amplifier based on a modulated supply voltage according to an example embodiment described above may be performed by at least one of the components included in the wireless communication device 1000 of FIG. 14. In some example embodiments, at least one of operations of the method of optimizing a delay value of an envelope signal and the method of operating a power amplifier based on a modulated supply voltage may be implemented as a plurality of instructions stored in the memory 1500. In some example embodiments, the ASIP 1300 executes a plurality of instructions stored in the memory 1500 to perform at least one of the operations of the methods.

## Claims

1. A method of optimizing a delay value of an envelope signal, the method comprising:
estimating, in a test mode, a plurality of adjacent channel leakage ratios respectively corresponding a plurality of test delay values based on a test output signal output from a power amplifier (300), wherein the test output signal is generated by the power amplifier (300) according to a test input signal corresponding to a plurality of selected frequencies which includes a first frequency and a second frequency;
selecting a test delay value corresponding to a largest value among the plurality of estimated adjacent channel leakage ratios; and
providing a modulated supply voltage (V_M) to the power amplifier (300) following an envelope signal delayed according to the selected test delay value in a normal mode,
wherein the estimating the plurality of adjacent channel leakage ratios comprises, for each of the plurality of test delay values, estimating a corresponding adjacent channel leakage ratio based on a ratio of a magnitude of a component corresponding to the plurality of frequencies included in the test output signal and a magnitude of an inter-modulated component of the test output signal,
wherein a half sampling frequency f_hsr corresponding to half of a sampling rate of the test output signal is greater than the first frequency f_1 and less than three times the first frequency f_1, which is included in the plurality of frequencies and corresponds to a fundamental frequency component of the test output signal,
wherein the estimating the plurality of adjacent channel leakage ratios comprises estimating the corresponding adjacent channel leakage ratio by dividing a magnitude of a component corresponding to one of the plurality of frequencies included in the test output signal by a magnitude of an aliased 3rd-order inter-modulated component at a 3^{rd}-order aliasing frequency f_a3, and
wherein the aliased 3rd-order inter-modulated component results from a 3rd-order inter-modulated component at a frequency greater than the half sampling frequency f_hsr being down-sampled, wherein a relationship between the 3rd-order aliasing frequency f_a3 and the first frequency f_1 is given by: $f_a 3 = 3 * f_ 1 - f_hsr * \left[3*f_1/f_hsr\right] .$

2. The method of claim 1, wherein the estimating the plurality of adjacent channel leakage ratios comprises:
providing the test input signal to a signal transmission path comprising the power amplifier (300) for each of the plurality of test delay values; and
providing the modulated supply voltage (V_M) to the power amplifier (300) by delaying the envelope signal of the test input signal based on a corresponding test delay value from among the plurality of test delay values.

3. The method of claim 1, wherein the test input signal comprises a tone signal corresponding to the plurality of frequencies.

4. The method of claim 1, wherein the test input signal comprises a plurality of frequency band components, and
wherein each of the plurality of frequency band components comprises components respectively corresponding to the plurality of frequencies, and a component of a unit band generated by one resource block.

5. The method of claim 1, wherein the inter-modulated component comprises any one or any combination of a 3rd-order inter-modulated component and a 5th-order inter-modulated component from a component corresponding to the plurality of frequencies included in the test input signal.

6. The method of claim 1, wherein the estimating the plurality of adjacent channel leakage ratios comprises:
converting the test output signal into a frequency domain for each of the plurality of test delay values;
obtaining a first aliasing frequency based on the half sampling frequency and the first frequency; and
estimating the plurality of adjacent channel leakage ratios based on a corresponding ratio of the magnitude of the component corresponding to the first frequency included in the test output signal and a magnitude of a component corresponding to the first aliasing frequency.

7. The method of claim 6, wherein the converting the test output signal into a frequency domain comprises performing a fast Fourier transform using the test output signal.

8. The method of claim 6, wherein the obtaining the first aliasing frequency comprises:
multiplying the first frequency by an order of inter-modulation to obtain a multiplication result;
dividing the multiplication result by the half sampling frequency to obtain a division result;
applying a Gaussian function to the division result to obtain a Gaussian function value; and
obtaining the first aliasing frequency by subtracting a value obtained by multiplying the Gaussian function value by the half sampling frequency from the multiplication result.

9. The method of claim 1, wherein the estimating the plurality of adjacent channel leakage ratios comprises:
obtaining a first ratio by dividing a magnitude of the fundamental frequency component corresponding to the first frequency by a magnitude of a first aliased inter-modulated component included in the test output signal; and
obtaining a second ratio by dividing a magnitude of the fundamental frequency component corresponding to the second frequency by a magnitude of a second aliased inter-modulated component included in the test output signal; and
estimating the corresponding adjacent channel leakage ratio by averaging the first ratio and the second ratio.

10. The method of claim 1, wherein the estimating the plurality of adjacent channel leakage ratios comprises:
obtaining a first average value by averaging a magnitude of the fundamental frequency component corresponding to the first frequency and a magnitude of the fundamental frequency component corresponding to the second frequency;
obtaining a second average value by averaging a magnitude of an aliased inter-modulated component of the fundamental frequency component corresponding to the first frequency and a magnitude of the aliased inter-modulated component of the fundamental frequency component corresponding to the second frequency; and
estimating the corresponding adjacent channel leakage ratio by dividing the first average value by the second average value.

11. A communication device (10, 1000) comprising:
a modem (100) configured to generate a tone signal corresponding to a plurality of selected frequencies, which includes a first frequency and a second frequency, as a test input signal in a test mode;
a power amplifier (300) configured to generate a test output signal based on the test input signal transmitted through a signal transmission path;
a voltage modulator (600) configured to sequentially generate a delayed envelope signal based on each of a plurality of test delay values and sequentially provide a modulated supply voltage (V_M) to the power amplifier (300) following the delayed envelope signal, based on each of the plurality of test delay values in the test mode; and
a controller (700) configured to estimate an adjacent channel leakage ratio based on a magnitude of a component corresponding to the plurality of selected frequencies included in the test output signal and a magnitude of an inter-modulated component for each of the plurality of test delay values in the test mode, select a test delay value corresponding to a largest value among a plurality of estimated channel leakage ratios, and control the voltage modulator (600) based on the test delay value in a normal mode,
wherein a half sampling frequency f_hsr corresponding to half of a sampling rate of the test output signal is greater than the first frequency f_1 and less than three times the first frequency f_1, which is included in the plurality of frequencies and corresponds to a fundamental frequency component of the test output signal,
wherein the estimating the plurality of adjacent channel leakage ratios comprises estimating the corresponding adjacent channel leakage ratio based on a magnitude of a component corresponding to one of the plurality of frequencies included in the test output signal by a magnitude of an aliased 3rd-order inter-modulated component at a 3^{rd}-order aliasing frequency f_a3, and
wherein the aliased 3rd-order inter-modulated component results from a 3rd-order inter-modulated component at a frequency greater than the half sampling frequency f_hsr being down-sampled, wherein a relationship between the 3rd-order aliasing frequency f_a3 and the first frequency f_1 is given by: $f_a 3 = 3 * f_ 1 - f_hsr * \left[3*f_1/f_hsr\right] .$

12. The communication device (10, 1000) of claim 11, wherein the estimating the plurality of adjacent channel leakage ratios comprises:
obtaining a first ratio by dividing a magnitude of the fundamental frequency component corresponding to the first frequency by a magnitude of a first aliased inter-modulated component included in the test output signal; and
obtaining a second ratio by dividing a magnitude of the fundamental frequency component corresponding to the second frequency by a magnitude of a second aliased inter-modulated component included in the test output signal; and
estimating the corresponding adjacent channel leakage ratio by averaging the first ratio and the second ratio.

13. The communication device (10, 1000) of claim 11, wherein the estimating the plurality of adjacent channel leakage ratios comprises:
obtaining a first average value by averaging a magnitude of the fundamental frequency component corresponding to the first frequency and a magnitude of the fundamental frequency component corresponding to the second frequency;
obtaining a second average value by averaging a magnitude of an aliased inter-modulated component of the fundamental frequency component corresponding to the first frequency and a magnitude of the aliased inter-modulated component of the fundamental frequency component corresponding to the second frequency; and
estimating the corresponding adjacent channel leakage ratio by dividing the first average value by the second average value.

## Patentansprüche

1. Verfahren zur Optimierung eines Verzögerungswerts eines Hüllkurvensignals, wobei das Verfahren umfasst:
Schätzen, in einem Testmodus, einer Vielzahl von Nachbarkanal-Leckageverhältnissen, die jeweils einer Vielzahl von Testverzögerungswerten entsprechen, basierend auf einem von einem Leistungsverstärker (300) ausgegebenen Testausgangssignal, wobei das Testausgangssignal durch den Leistungsverstärker (300) gemäß einem Testeingangssignal erzeugt wird, das einer Vielzahl von ausgewählten Frequenzen entspricht, die eine erste Frequenz und eine zweite Frequenz beinhalten;
Auswählen eines Testverzögerungswerts, der einem größten Wert unter der Vielzahl von geschätzten Nachbarkanal-Leckageverhältnissen entspricht; und
Bereitstellen einer modulierten Versorgungsspannung (V_M) an den Leistungsverstärker (300) im Anschluss an ein Hüllkurvensignal, das gemäß dem ausgewählten Testverzögerungswert in einem Normalmodus verzögert wurde,
wobei das Schätzen der Vielzahl von Nachbarkanal-Leckageverhältnissen für jeden von der Vielzahl von Testverzögerungswerten ein Schätzen eines entsprechenden Nachbarkanal-Leckageverhältnisses basierend auf einem Verhältnis zwischen einer Amplitude einer Komponente, die der in dem Testausgangssignal enthaltenen Vielzahl von Frequenzen entspricht, und einer Amplitude einer intermodulierten Komponente des Testausgangssignals umfasst,
wobei eine halbe Abtastfrequenz f_hsr, die einer Hälfte einer Abtastrate des Testausgangssignals entspricht, größer ist als die erste Frequenz f_1 und kleiner ist als das Dreifache der ersten Frequenz f_1, die in der Vielzahl von Frequenzen enthalten ist und einer Grundfrequenzkomponente des Testausgangssignals entspricht,
wobei das Schätzen der Vielzahl von Nachbarkanal-Leckageverhältnissen ein Schätzen des entsprechenden Nachbarkanal-Leckageverhältnisses durch Dividieren einer Amplitude einer Komponente, die einer von der Vielzahl von in dem Testausgangssignal enthaltenen Frequenzen entspricht, durch eine Amplitude einer aliasierten intermodulierten Komponente 3. Ordnung bei einer Aliasing-Frequenz f_a3 3. Ordnung umfasst, und
wobei die aliasierte intermodulierte Komponente 3. Ordnung aus einer intermodulierten Komponente 3. Ordnung bei einer Frequenz resultiert, die größer ist als die halbe Abtastfrequenz f_hsr, die heruntergetaktet wird, wobei eine Beziehung zwischen der Aliasing-Frequenz f_a3 3. Ordnung und der ersten Frequenz f_1 gegeben ist durch: $f_a 3 = 3 * f_ 1 - f_hsr * \left[3*f_1/f_hsr\right] .$

2. Verfahren nach Anspruch 1, wobei das Schätzen von der Vielzahl von Nachbarkanal-Leckageverhältnissen umfasst:
Bereitstellen des Test-Eingangssignals an einen Signalübertragungspfad, der den Leistungsverstärker (300) aufweist, für jeden von der Vielzahl von Testverzögerungswerten; und
Bereitstellen der modulierten Versorgungsspannung (V_M) an den Leistungsverstärker (300) durch Verzögern des Hüllkurvensignals des Test-Eingangssignals basierend auf einem entsprechenden Testverzögerungswert aus der Vielzahl von Testverzögerungswerten.

3. Verfahren nach Anspruch 1, wobei das Test-Eingangssignal ein Tonsignal aufweist, das der Vielzahl von Frequenzen entspricht.

4. Verfahren nach Anspruch 1, wobei das Test-Eingangssignal eine Vielzahl von Frequenzbandkomponenten aufweist und
wobei jede von der Vielzahl von Frequenzbandkomponenten Komponenten aufweist, die jeweils der Vielzahl von Frequenzen entsprechen, sowie eine Komponente eines Einheitsbandes aufweist, die durch einen Ressourcenblock erzeugt wird.

5. Verfahren nach Anspruch 1, wobei die intermodulierte Komponente eine beliebige einzelne von oder eine beliebige Kombination aus einer intermodulierten Komponente 3. Ordnung und einer intermodulierten Komponente 5. Ordnung von einer Komponente aufweist, die der in dem Test-Eingangssignal enthaltenen Vielzahl von Frequenzen entspricht.

6. Verfahren nach Anspruch 1, wobei das Schätzen der Vielzahl von Nachbarkanal-Leckageverhältnissen umfasst:
Umwandeln des Testausgangssignals in einen Frequenzbereich für jeden von der Vielzahl von Testverzögerungswerten;
Ermitteln einer ersten Aliasing-Frequenz basierend auf der halben Abtastfrequenz und der ersten Frequenz; und
Schätzen der Vielzahl von Nachbarkanal-Leckageverhältnissen basierend auf einem entsprechenden Verhältnis zwischen der Amplitude der Komponente, die der in dem Testausgangssignal enthaltenen ersten Frequenz entspricht, und einer Amplitude einer Komponente, die der ersten Aliasing-Frequenz entspricht.

7. Verfahren nach Anspruch 6, wobei das Umwandeln des Testausgangssignals in einen Frequenzbereich ein Durchführen einer schnellen Fourier-Transformation unter Verwendung des Testausgangssignals umfasst.

8. Verfahren nach Anspruch 6, wobei das Ermitteln der ersten Aliasing-Frequenz umfasst:
Multiplizieren der ersten Frequenz mit einer Intermodulationsordnung, um ein Multiplikationsergebnis zu ermitteln;
Dividieren des Multiplikationsergebnisses durch die halbe Abtastfrequenz, um ein Divisionsergebnis zu ermitteln;
Anwenden einer Gauß-Funktion auf das Divisionsergebnis, um einen Gauß-Funktionswert zu erhalten; und
Ermitteln der ersten Aliasing-Frequenz durch Subtrahieren eines Wertes, der durch Multiplikation des Gauß-Funktionswertes mit der halben Abtastfrequenz erhalten wurde, von dem Multiplikationsergebnis.

9. Verfahren nach Anspruch 1, wobei das Schätzen von der Vielzahl von Nachbarkanal-Leckageverhältnissen umfasst:
Ermitteln eines ersten Verhältnisses durch Dividieren einer Amplitude der Grundfrequenzkomponente, die der ersten Frequenz entspricht, durch eine Amplitude einer ersten aliasierten, intermodulierten Komponente, die in dem Testausgangssignal enthalten ist; und
Ermitteln eines zweiten Verhältnisses durch Dividieren einer Amplitude der Grundfrequenzkomponente, die der zweiten Frequenz entspricht, durch eine Amplitude einer zweiten aliasierten, intermodulierten Komponente, die im Testausgangssignal enthalten ist; und
Schätzen des entsprechenden Nachbarkanal-Leckageverhältnisses durch Mittelwertbildung aus dem ersten Verhältnis und dem zweiten Verhältnis.

10. Verfahren nach Anspruch 1, wobei das Schätzen der Vielzahl von Nachbarkanal-Leckageverhältnissen umfasst:
Ermitteln eines ersten Mittelwerts durch Mittelwertbildung aus einer Amplitude der Grundfrequenzkomponente, die der ersten Frequenz entspricht, und einer Amplitude der Grundfrequenzkomponente, die der zweiten Frequenz entspricht;
Ermitteln eines zweiten Mittelwerts durch Mittelwertbildung aus einer Amplitude einer aliasierten intermodulierten Komponente der der ersten Frequenz entsprechenden Grundfrequenzkomponente und einer Amplitude der aliasierten intermodulierten Komponente der der zweiten Frequenz entsprechenden Grundfrequenzkomponente; und Schätzen des entsprechenden Nachbarkanal-Leckageverhältnisses durch Dividieren des ersten Mittelwerts durch den zweiten Mittelwert.

11. Kommunikationsvorrichtung (10, 1000), aufweisend:
ein Modem (100), das so konfiguriert ist, dass es ein Tonsignal, das einer Vielzahl von ausgewählten Frequenzen entspricht, die eine erste Frequenz und eine zweite Frequenz beinhalten, als ein Test-Eingangssignal in einem Testmodus erzeugt;
einen Leistungsverstärker (300), der so konfiguriert ist, dass er ein Test-Ausgangssignal basierend auf dem über einen Signalübertragungspfad übertragenen Test-Eingangssignals erzeugt;
einen Spannungsmodulator (600), der so konfiguriert ist, dass er, im Testmodus basierend auf jedem von der Vielzahl von Testverzögerungswerten, sequenziell ein verzögertes Hüllkurvensignal basierend auf jedem von der Vielzahl von Testverzögerungswerten erzeugt und dem Leistungsverstärker (300) sequenziell eine modulierte Versorgungsspannung (V_M) im Anschluss an das verzögerte Hüllkurvensignal zuführt; und
einen Controller (700), der so konfiguriert ist, dass er im Testmodus basierend auf einer Amplitude einer Komponente, die der in dem Testausgangssignal enthaltenen Vielzahl von ausgewählten Frequenzen entspricht, und der Amplitude einer intermodulierten Komponente für jeden von der Vielzahl von Testverzögerungswerten ein Nachbarkanal-Leckageverhältnis schätzt, einen Testverzögerungswert auswählt, der einem größten Wert unter der Vielzahl von geschätzten Nachbarkanal-Leckageverhältnissen entspricht, und den Spannungsmodulator (600) basierend auf dem Testverzögerungswert in einem Normalmodus steuert,
wobei eine halbe Abtastfrequenz f_hsr, die der Hälfte einer Abtastrate des Testausgangssignals entspricht, größer ist als die erste Frequenz f_1 und kleiner ist als das Dreifache der ersten Frequenz f_1, die in der Vielzahl von Frequenzen enthalten ist und einer Grundfrequenzkomponente des Testausgangssignals entspricht,
wobei das Schätzen der Vielzahl von Nachbarkanal-Leckageverhältnissen ein Schätzen des entsprechenden Nachbarkanal-Leckageverhältnisses basierend auf einer Amplitude einer Komponente, die einer von der Vielzahl von in dem Testausgangssignal enthaltenen Frequenzen entspricht, anhand einer Amplitude einer aliasierten intermodulierten Komponente 3. Ordnung bei einer Aliasing-Frequenz f_a3 3. Ordnung umfasst, und
wobei die aliasierte intermodulierte Komponente 3. Ordnung aus einer intermodulierten Komponente 3. Ordnung bei einer Frequenz resultiert, die größer ist als die halbe Abtastfrequenz f_hsr, die heruntergetaktet wird, wobei eine Beziehung zwischen der Aliasing-Frequenz f_a3 3. Ordnung und der ersten Frequenz f_1 gegeben ist durch: $f_a 3 = 3 * f_ 1 - f_hsr * \left[3*f_1/f_hsr\right] .$

12. Kommunikationsvorrichtung (10, 1000) nach Anspruch 11, wobei das Schätzen der Vielzahl von Nachbarkanal-Leckageverhältnissen umfasst:
Ermitteln eines ersten Verhältnisses durch Dividieren einer Amplitude der der ersten Frequenz entsprechenden Grundfrequenzkomponente durch eine Amplitude einer ersten aliasierten intermodulierten Komponente, die in dem Testausgangssignal enthalten ist; und
Ermitteln eines zweiten Verhältnisses durch Dividieren einer Amplitude der der zweiten Frequenz entsprechenden Grundfrequenzkomponente durch eine Amplitude einer zweiten aliasierten intermodulierten Komponente, die in dem Testausgangssignal enthalten ist; und
Schätzen des entsprechenden Nachbarkanal-Leckageverhältnisses durch Mittelwertbildung des ersten Verhältnisses und des zweiten Verhältnisses.

13. Kommunikationsvorrichtung (10, 1000) nach Anspruch 11, wobei das Schätzen der Vielzahl von Nachbarkanal-Leckageverhältnissen umfasst:
Ermitteln eines ersten Mittelwerts durch Mittelwertbildung einer Amplitude der Grundfrequenzkomponente, die der ersten Frequenz entspricht, und einer Amplitude der Grundfrequenzkomponente, die der zweiten Frequenz entspricht;
Ermitteln eines zweiten Mittelwerts durch Mittelwertbildung aus einer Amplitude einer aliasierten intermodulierten Komponente der der ersten Frequenz entsprechenden Grundfrequenzkomponente und einer Amplitude der aliasierten intermodulierten Komponente der der zweiten Frequenz entsprechenden Grundfrequenzkomponente; und Schätzen des entsprechenden Nachbarkanal-Leckageverhältnisses durch Dividieren des ersten Mittelwerts durch den zweiten Mittelwert.

## Revendications

1. Procédé d'optimisation d'une valeur de retard d'un signal d'enveloppe, le procédé comprenant :
l'estimation, dans un mode de test, d'une pluralité de rapports de fuite de canal adjacent correspondant respectivement à une pluralité de valeurs de retard de test, sur la base d'un signal de sortie de test délivré par un amplificateur de puissance (300), dans lequel le signal de sortie de test est généré par l'amplificateur de puissance (300) selon un signal d'entrée de test correspondant à une pluralité de fréquences sélectionnées qui comprend une première fréquence et une deuxième fréquence ;
la sélection d'une valeur de retard de test correspondant à la valeur la plus grande parmi la pluralité de rapports de fuite de canal adjacent estimés ; et
la fourniture d'une tension d'alimentation modulée (V_M) à l'amplificateur de puissance (300) en suivant un signal d'enveloppe retardé selon la valeur de retard de test sélectionnée dans un mode normal,
dans lequel l'estimation de la pluralité de rapports de fuite de canal adjacent comprend, pour chacune de la pluralité de valeurs de retard de test, l'estimation d'un rapport de fuite de canal adjacent correspondant sur la base d'un rapport entre une amplitude d'une composante correspondant à la pluralité de fréquences comprises dans le signal de sortie de test et une amplitude d'une composante intermodulée du signal de sortie de test,
dans lequel une demi-fréquence d'échantillonnage f_hsr correspondant à la moitié d'une fréquence d'échantillonnage du signal de sortie de test est supérieure à la première fréquence f_1 et inférieure à trois fois la première fréquence f_1, laquelle est comprise dans la pluralité de fréquences et correspond à une composante de fréquence fondamentale du signal de sortie de test,
dans lequel l'estimation de la pluralité de rapports de fuite de canal adjacent comprend l'estimation du rapport de fuite de canal adjacent correspondant en divisant une amplitude d'une composante correspondant à l'une de la pluralité de fréquences comprises dans le signal de sortie de test par une amplitude d'une composante intermodulée du troisième ordre repliée à une fréquence de repliement du troisième ordre f_a3, et
dans lequel la composante intermodulée du troisième ordre repliée résulte du fait qu'une composante intermodulée du troisième ordre à une fréquence supérieure à la une demi-fréquence d'échantillonnage f_hsr est sous-échantillonnée, une relation entre la fréquence de repliement du troisième ordre f_a3 et la première fréquence f_1 étant donnée par : $f_a 3 = 3 * f_ 1 - f_hsr * \left[3*f_1/f_hsr\right] .$

2. Procédé selon la revendication 1, dans lequel l'estimation de la pluralité de rapports de fuite de canal adjacent comprend :
la fourniture du signal d'entrée de test à un trajet de transmission de signal comprenant l'amplificateur de puissance (300) pour chacune de la pluralité de valeurs de retard de test ; et
la fourniture de la tension d'alimentation modulée (V_M) à l'amplificateur de puissance (300) en retardant le signal d'enveloppe du signal d'entrée de test sur la base d'une valeur de retard de test correspondante parmi la pluralité de valeurs de retard de test.

3. Procédé selon la revendication 1, dans lequel le signal d'entrée de test comprend un signal de tonalité correspondant à la pluralité de fréquences.

4. Procédé selon la revendication 1, dans lequel le signal d'entrée de test comprend une pluralité de composantes de bande de fréquences, et
dans lequel chacune de la pluralité de composantes de bande de fréquences comprend des composantes correspondant respectivement à la pluralité de fréquences, et une composante d'une bande unitaire générée par un bloc de ressources.

5. Procédé selon la revendication 1, dans lequel la composante intermodulée comprend une composante intermodulée du troisième ordre, une composante intermodulée du cinquième ordre, ou toute combinaison de celles-ci, générée à partir d'une composante correspondant à la pluralité de fréquences comprises dans le signal d'entrée de test.

6. Procédé selon la revendication 1, dans lequel l'estimation de la pluralité de rapports de fuite de canal adjacent comprend :
la conversion du signal de sortie de test en domaine fréquentiel pour chacune de la pluralité de valeurs de retard de test ;
l'obtention d'une première fréquence de repliement sur la base de la demi-fréquence d'échantillonnage correspondant à la moitié de la fréquence d'échantillonnage et de la première fréquence ; et
l'estimation de la pluralité de rapports de fuite de canal adjacent sur la base d'un rapport correspondant entre l'amplitude de la composante correspondant à la première fréquence comprise dans le signal de sortie de test et l'amplitude d'une composante correspondant à la première fréquence de repliement.

7. Procédé selon la revendication 6, dans lequel la conversion du signal de sortie de test en domaine fréquentiel comprend l'exécution d'une transformée de Fourier rapide en utilisant le signal de sortie de test.

8. Procédé selon la revendication 6, dans lequel l'obtention de la première fréquence de repliement comprend :
la multiplication de la première fréquence par un ordre d'intermodulation afin d'obtenir un résultat de multiplication ;
la division du résultat de multiplication par la demi-fréquence d'échantillonnage correspondant à la moitié de la fréquence d'échantillonnage afin d'obtenir un résultat de division ;
l'application d'une fonction gaussienne au résultat de division afin d'obtenir une valeur de fonction gaussienne ; et
l'obtention de la première fréquence de repliement en soustrayant, du résultat de multiplication, une valeur obtenue en multipliant la valeur de fonction gaussienne par la demi-fréquence d'échantillonnage correspondant à la moitié de la fréquence d'échantillonnage.

9. Procédé selon la revendication 1, dans lequel l'estimation de la pluralité de rapports de fuite de canal adjacent comprend :
l'obtention d'un premier rapport en divisant l'amplitude de la composante de fréquence fondamentale correspondant à la première fréquence par l'amplitude d'une première composante intermodulée repliée comprise dans le signal de sortie de test ; et
l'obtention d'un deuxième rapport en divisant l'amplitude de la composante de fréquence fondamentale correspondant à la deuxième fréquence par l'amplitude d'une deuxième composante intermodulée repliée comprise dans le signal de sortie de test ; et
l'estimation du rapport de fuite de canal adjacent correspondant en faisant la moyenne du premier rapport et du deuxième rapport.

10. Procédé selon la revendication 1, dans lequel l'estimation de la pluralité de rapports de fuite de canal adjacent comprend :
l'obtention d'une première valeur moyenne en faisant la moyenne de l'amplitude de la composante de fréquence fondamentale correspondant à la première fréquence et de l'amplitude de la composante de fréquence fondamentale correspondant à la deuxième fréquence ;
l'obtention d'une deuxième valeur moyenne en faisant la moyenne de l'amplitude d'une composante intermodulée repliée de la composante de fréquence fondamentale correspondant à la première fréquence et de l'amplitude de la composante intermodulée repliée de la composante de fréquence fondamentale correspondant à la deuxième fréquence ; et
l'estimation du rapport de fuite de canal adjacent correspondant en divisant la première valeur moyenne par la deuxième valeur moyenne.

11. Dispositif de communication (10, 1000) comprenant :
un modem (100) configuré pour générer un signal de tonalité correspondant à une pluralité de fréquences sélectionnées, laquelle comprend une première fréquence et une deuxième fréquence, en tant que signal d'entrée de test dans un mode de test ;
un amplificateur de puissance (300) configuré pour générer un signal de sortie de test sur la base du signal d'entrée de test transmis par l'intermédiaire d'un trajet de transmission de signal ;
un modulateur de tension (600) configuré pour générer successivement un signal d'enveloppe retardé sur la base de chacune d'une pluralité de valeurs de retard de test et pour fournir successivement une tension d'alimentation modulée (V_M) à l'amplificateur de puissance (300) en suivant le signal d'enveloppe retardé, sur la base de chacune de la pluralité de valeurs de retard de test dans le mode de test ; et
un contrôleur (700) configuré pour estimer un rapport de fuite de canal adjacent sur la base d'une amplitude d'une composante correspondant à la pluralité de fréquences sélectionnées comprises dans le signal de sortie de test et d'une amplitude d'une composante intermodulée pour chacune de la pluralité de valeurs de retard de test dans le mode de test, sélectionner une valeur de retard de test correspondant à une valeur la plus grande parmi une pluralité de rapports de fuite de canal estimés, et commander le modulateur de tension (600) sur la base de la valeur de retard de test dans un mode normal,
dans lequel une demi-fréquence d'échantillonnage f_hsr correspondant à la moitié d'une fréquence d'échantillonnage du signal de sortie de test est supérieure à la première fréquence f_1 et inférieure à trois fois la première fréquence f_1, laquelle est comprise dans la pluralité de fréquences et correspond à une composante de fréquence fondamentale du signal de sortie de test,
dans lequel l'estimation de la pluralité de rapports de fuite de canal adjacent comprend l'estimation du rapport de fuite de canal adjacent correspondant sur la base de l'amplitude d'une composante correspondant à l'une de la pluralité de fréquences comprises dans le signal de sortie de test par l'amplitude d'une composante intermodulée du troisième ordre repliée à une fréquence de repliement du troisième ordre f_a3, et
dans lequel la composante intermodulée du troisième ordre repliée résulte du fait qu'une composante intermodulée du troisième ordre à une fréquence supérieure à la une demi-fréquence d'échantillonnage f_hsr est sous-échantillonnée, une relation entre la fréquence de repliement du troisième ordre f_a3 et la première fréquence f_1 étant donnée par : $f_a 3 = 3 * f_ 1 - f_hsr * \left[3*f_1/f_hsr\right] .$

12. Dispositif de communication (10, 1000) selon la revendication 11, dans lequel l'estimation de la pluralité de rapports de fuite de canal adjacent comprend :
l'obtention d'un premier rapport en divisant l'amplitude de la composante de fréquence fondamentale correspondant à la première fréquence par l'amplitude d'une première composante intermodulée repliée comprise dans le signal de sortie de test ; et
l'obtention d'un deuxième rapport en divisant l'amplitude de la composante de fréquence fondamentale correspondant à la deuxième fréquence par l'amplitude d'une deuxième composante intermodulée repliée comprise dans le signal de sortie de test ; et
l'estimation du rapport de fuite de canal adjacent correspondant en faisant la moyenne du premier rapport et du deuxième rapport.

13. Dispositif de communication (10, 1000) selon la revendication 11, dans lequel l'estimation de la pluralité de rapports de fuite de canal adjacent comprend :
l'obtention d'une première valeur moyenne en faisant la moyenne de l'amplitude de la composante de fréquence fondamentale correspondant à la première fréquence et de l'amplitude de la composante de fréquence fondamentale correspondant à la deuxième fréquence ;
l'obtention d'une deuxième valeur moyenne en faisant la moyenne de l'amplitude d'une composante intermodulée repliée de la composante de fréquence fondamentale correspondant à la première fréquence et de l'amplitude de la composante intermodulée repliée de la composante de fréquence fondamentale correspondant à la deuxième fréquence ; et
l'estimation du rapport de fuite de canal adjacent correspondant en divisant la première valeur moyenne par la deuxième valeur moyenne.
